# EUROPÄISCHE PATENTSCHRIFT

(11) **EP 3 651 479 B1**
(45) Veröffentlichungstag und Bekanntmachung des Hinweises auf die Patenterteilung: **01.06.2022**
(21) Anmeldenummer: 18306463.3
(22) Anmeldetag: 08.11.2018
(51) Int. Cl.: H04R 31/00

(54) **HERSTELLUNGSVERFAHREN FÜR ZUMINDEST EINE MEMBRANEINHEIT EINES MEMS-WANDLERS**
METHOD FOR PRODUCING AT LEAST ONE MEMBRANE UNIT OF A MEMS CONVERTER
PROCÉDÉ DE FABRICATION D'AU MOINS UNE UNITÉ MEMBRANE D'UN TRANSDUCTEUR MEMS

(43) Veröffentlichungstag der Anmeldung: 13.05.2020
(73) Patentinhaber: Usound GmbH, 8020 Graz (AT)
(72) Erfinder: RUSCONI CLERICI BELTRAMI, Andrea, 1130 Wien (AT); BOTTONI, Ferruccio, 8020 Graz (AT); RENAUD-BEZOT, Nick, 1050 Wien (AT)
(74) Vertreter: Canzler & Bergmeier Patentanwälte Partnerschaft mbB

(56) Entgegenhaltungen:
- WO-A1-2016/180820
- US-A1- 2010 033 201
- US-A1- 2012 049 298

## Beschreibung

Die vorliegende Erfindung betrifft ein Herstellungsverfahren für zumindest eine Membraneinheit eines MEMS-Wandlers, bei dem auf einem Träger mehrere piezoelektrische Wandlereinheiten mit jeweils zumindest einer Elektrodenschicht und zumindest einer Piezoschicht ausgebildet werden. Aus der DE 603 13 715 T2 ist ein Verfahren zum Herstellen eines MEMS-Wandlers bekannt. Dies erfolgt dadurch, dass eine Opferschicht auf ein Substrat aufgebracht wird. Danach wird aufeinanderfolgend eine Membranschicht, eine untere Elektrodenschicht, eine aktive Schicht und eine obere Elektrodenschicht aufgebracht. Nachteilig daran ist es, dass eine Flexibilität des Herstellungsverfahrens eingeschränkt ist. Weitere Herstellungsverfahren bzw. entsprechende MEMS-Wandler sind aus WO 2016/180820 A1 und US 2012/049298 A1 bekannt.

Aufgabe der vorliegenden Erfindung ist es somit, ein Herstellungsverfahren einer Membraneinheit eines MEMS-Wandlers flexibler gestalten zu können.

Die Aufgabe wird gelöst durch ein Herstellungsverfahren mit den Merkmalen des unabhängigen Patentanspruchs.

Vorgeschlagen wird ein Herstellungsverfahren für zumindest eine Membraneinheit eines MEMS-Wandlers. MEMS ist eine Abkürzung und steht für mikroelektromechanische Systeme. Mit Hilfe des MEMS-Wandlers können elektrische Signale in Bewegungen und Bewegungen in elektrische Signale umgewandelt werden. So kann der MEMS-Wandler zum Erzeugen und/oder Erfassen von Schallwellen benutzt werden. Der MEMS-Wandler kann somit als Lautsprecher und/oder als Mikrofon verwendet werden. Der MEMS-Wandler wandelt dabei ein elektrisches Signal, das ein Audiosignal umfasst, in Schall um. Der MEMS-Wandler kann jedoch auch den Schall erfassen und in ein elektrisches Signal, welches wiederum ein Audiosignal umfasst, umwandeln.

Der MEMS-Wandler wandelt dabei das elektrische Signal in eine Auslenkung um, welche auf eine Membran der Membraneinheit übertragen werden kann. Die Auslenkung erzeugt einen Druck auf ein umgebendes Medium, insbesondere Luft, und regt es zu schwingen an, wodurch der Schall erzeugt wird. Trifft dagegen eine Druckschwankung, beispielsweise in Form von Schall, auf die Membran, wird diese ausgelenkt und überträgt die Auslenkung auf die Wandlereinheit, welche die Auslenkung in ein elektrisches Signal umsetzt. Dadurch kann der Schall erfasst werden. Der MEMS-Wandler kann weiterhin dazu benutzt werden, um Schall im hörbaren Wellenlängenspektrum zu erfassen und/oder zu erzeugen. Der MEMS-Wandler kann beispielsweise in einem Smartphone, einem Computer, einem MP3-Player oder sonstigen Geräten zum Abspielen von Musik oder zur Aufnahme von Schall eingesetzt werden. Zusätzlich oder alternativ kann der MEMS-Wandler aber auch für Pumpenanordnungen verwendet werden, um ein Medium mit einem Druck zu beaufschlagen. Der MEMS-Wandler kann beispielsweise in einer Mikropumpe bzw. in der Mikromechanik eingesetzt werden.

Die Membraneinheit kann beispielsweise auf eine Leiterplatte angeordnet werden, um den MEMS-Wandler zu bilden. Beispielsweise kann die Membraneinheit über eine Öffnung und/oder ein Loch in der Leiterplatte angeordnet werden, so dass die Membraneinheit frei schwingen kann. Dadurch ist der MEMS-Wandler ausgebildet, der Schall erzeugen und/oder erfassen kann. Die Membraneinheit kann über die Öffnung und/oder das Loch gespannt werden. Die Membraneinheit kann zusätzlich oder alternativ auch in ein Gehäuse angeordnet, insbesondere eingespannt werden, um beispielsweise einen In-Ear-Hörer, beispielsweise ein Hörgerät, zu bilden.

Beim Herstellungsverfahren werden auf einem Träger mehrere piezoelektrische Wandlereinheiten mit jeweils zumindest einer Elektrodenschicht und zumindest einer Piezoschicht ausgebildet. Die Piezoschicht ist aus einem Piezomaterial ausgebildet. Die Piezoschicht lenkt sich aus, wenn sie mit einem elektrischen Signal beaufschlagt wird. Dagegen erzeugt die Piezoschicht ein elektrisches Signal, wenn sie selbst ausgelenkt wird.

Der Träger kann beispielsweise ein Siliziumwafer, eine Glasscheibe, ein Metall, eine Metallfolie und/oder ein Epitaxiewafer sein. Der Träger dient als Grundgerüst, auf dem die Wandlereinheiten aufgebaut werden. Der Träger kann beispielsweise eine Dicke von mindestens 500 µm aufweisen. Insbesondere ist er einige Millimeter dick. Dadurch kann der Träger gut gehandhabt werden.

Mit Hilfe der zumindest einen Elektrodenschicht kann das elektrische Signal zur Piezoschicht geführt und von der Piezoschicht weggeführt werden. Zwischen der zumindest einen Elektrodenschicht und der Piezoschicht ist vorteilhafterweise eine elektrische Verbindung ausgebildet.

Die Wandlereinheit umfasst zumindest die zumindest eine Elektrodenschicht und die zumindest eine Piezoschicht.

Erfindungsgemäß wird der Träger von den Wandlereinheiten entfernt. Dadurch werden die Wandlereinheiten zumindest teilweise voneinander getrennt, so dass sie zwischengelagert und nach Bedarf weiterverarbeitet werden können. Es kann eine Vielzahl an Wandlereinheiten ausgebildet werden, wobei noch nicht festgelegt sein muss, wie die Membraneinheit später ausgebildet sein wird. Die Herstellung der Wandlereinheiten ist im Wesentlichen unabhängig von der Herstellung der Membraneinheiten. Die Herstellung der Wandlereinheiten kann standardisiert werden. Dadurch und durch die Herstellung einer hohen Anzahl an Wandlereinheiten, die untereinander eine hohe Ähnlichkeit aufweisen können, ist eine hohe Flexibilität für die Herstellung der Membraneinheit und somit des MEMS-Wandlers gegeben. Die Wandlereinheiten können im nächsten Herstellungsschritt nahezu beliebig auf einer Membran angeordnet werden, so dass ein breites Spektrum an unterschiedlichen Formen und Gestaltungen der Membraneinheiten und somit der MEMS-Wandler ermöglicht ist.

Des Weiteren wird zumindest eine der Wandlereinheiten zur Ausbildung der zumindest einen Membraneinheit auf der Membran angeordnet und mit dieser verbunden. Das Herstellungsverfahren umfasst somit die Schritte, dass zuerst die Wandlereinheiten hergestellt werden und diese dann auf die Membran, die bereits vorhanden sein kann, angeordnet und mit dieser verbunden werden. Dadurch können die Wandlereinheiten in hoher Stückzahl hergestellt werden, ohne dass beispielsweise geplant werden muss, wie die Membraneinheit später aussieht. Ferner können die Wandlereinheiten auf deren Funktionsfähigkeit getestet werden und fehlerhafte Wandlereinheiten aus der Produktion genommen werden. Des Weiteren kann während dem Herstellungsverfahren ein Design der Membraneinheit neu festgelegt oder geändert werden. Die Wandlereinheiten können außerdem in beliebiger Form, Anordnung, Gestaltung und/oder Geometrie auf der Membran platziert werden. Ferner können, wenn es gewünscht ist, auch mehrere Wandlereinheiten eine Membraneinheit ausbilden. Die Wandlereinheiten können beispielsweise beim Anordnen auf der Membran gruppiert werden, um die Membraneinheit zu bilden.

Von Vorteil ist es, wenn die Wandlereinheiten voneinander getrennt auf dem Träger ausgebildet werden. Dadurch ist das Weiterverarbeiten vereinfacht, da beispielsweise beim Entfernen des Trägers von den Wandlereinheiten bereits die einzelnen Wandlereinheiten abgetrennt werden. Die Wandlereinheiten müssen nicht mehr voneinander getrennt werden.

Zusätzlich oder alternativ können die Wandlereinheiten vor oder nach dem Entfernen des Trägers voneinander getrennt werden. Wenn die Wandlereinheiten voneinander getrennt werden, wenn sie noch auf dem Träger angeordnet sind, kann der Träger mit den Wandlereinheiten einfacher gehandhabt werden. Werden dagegen die Wandlereinheiten nach dem Entfernen des Trägers getrennt, können die Wandlereinheiten flexibel und beispielsweise erst dann abgetrennt werden, wenn sie gebraucht werden. Zusätzlich oder alternativ können auch lediglich so viele Wandlereinheiten abgetrennt werden, wie gebraucht werden.

Vorteilhaft ist es, wenn die Wandlereinheiten derart voneinander getrennt ausgebildet und/oder voneinander getrennt werden, dass zumindest eine vereinzelte Wandlereinheit ausgebildet wird. Dadurch liegen einzelne Wandlereinheiten vor, die beispielsweise gemäß einer Anforderung, in einer speziellen Geometrie oder Anordnung auf der Membran angeordnet werden können. Die Wandlereinheiten können zusätzlich oder alternativ auch derart voneinander getrennt ausgebildet und/oder voneinander getrennt werden, dass zumindest eine zusammenhängende Gruppe von zumindest zwei Wandlereinheiten ausgebildet wird. Dadurch kann die Anordnung der Wandlereinheiten auf der Membran vereinfacht werden, wenn die Membraneinheit, beispielsweise gemäß einer Anforderung oder weil es für eine Anwendung nützlich ist, zumindest zwei Wandlereinheiten umfassen soll.

Von Vorteil ist es, wenn auf dem Träger eine Trägerschicht ausgebildet wird, auf der die zumindest eine Elektrodenschicht und die zumindest eine Piezoschicht der Wandlereinheiten ausgebildet werden. Mit Hilfe der Trägerschicht können beispielsweise Unebenheiten des Trägers ausgeglichen werden, so dass eine definierte Oberfläche für die zumindest eine Elektrodenschicht und die zumindest eine Piezoschicht gegeben ist. Die Trägerschicht kann aber auch dazu dienen, den Träger von den Wandlereinheiten zu entfernen. Es kann beispielsweise vorteilhaft sein, den Träger wiederzuverwenden. Der Träger kann beispielsweise als Siliziumwafer ausgebildet sein, der kostspielig in der Anschaffung ist, so dass es sinnvoll sein kann, ihn wiederzuverwenden. Mit Hilfe der Trägerschicht kann das Entfernen des Trägers von den Wandlereinheiten vereinfacht werden. Die Trägerschicht kann beispielsweise teilweise entfernt werden, so dass der Träger von den Wandlereinheiten entfernbar ist. Die Trägerschicht kann beispielsweise als Epitaxieschicht auf dem Träger ausgebildet sein.

Zusätzlich oder alternativ kann die Trägerschicht auch einen Teil der Wandlereinheiten bilden. Die Trägerschicht kann beispielsweise eine Steifigkeit aufweisen, die höher ist als die der Piezoschicht, so dass sich die Piezoschicht gegen die Trägerschicht auslenken kann. Die Trägerschicht kann somit ein Fixierelement für die Wandlereinheiten bilden. Die Trägerschicht kann somit als Ankerpunkt oder Halteschicht dienen.

Zusätzlich oder alternativ können die zumindest eine Elektrodenschicht, die zumindest eine Piezoschicht und/oder die Trägerschicht übereinander auf dem Träger ausgebildet werden. Dadurch werden die Wandlereinheiten schichtweise aufgebaut und erstrecken sich von dem Träger weg.

Vorteilhafterweise werden eine erste und eine zweite Elektrodenschicht auf dem Träger ausgebildet. Mit Hilfe der beiden Elektrodenschichten kann ein Stromkreis mit der Piezoschicht ausgebildet werden. Dabei kann eine der beiden Elektrodenschichten als Masse bzw. Bezugspotential dienen.

Zusätzlich oder alternativ ist es vorteilhaft, wenn die Piezoschicht zwischen der ersten und der zweiten Elektrodenschicht ausgebildet wird. Die Piezoschicht wird dadurch von oben und von unten mittels den beiden Elektrodenschichten kontaktiert.

Von Vorteil ist es, wenn zuerst die erste Elektrodenschicht, dann die Piezoschicht und dann die zweite Elektrodenschicht ausgebildet werden. Dadurch können schichtweise die Wandlereinheiten ausgebildet werden, wobei die Piezoschicht zwischen den beiden Elektrodenschichten ausgebildet wird. Zusätzlich oder alternativ kann zuvor die Trägerschicht ausgebildet werden. Dadurch ist die Trägerschicht die unterste Schicht.

Vorteilhafterweise werden die Wandlereinheiten schichtweise mittels eines, insbesondere selektiven, Abscheideverfahrens und/oder eines Beschichtungsverfahrens ausgebildet. Die Verfahren sind dabei bei der Herstellung von mikroelektronischen Bauteilen üblich. Bei dem Abscheideverfahren kann es sich beispielsweise um ein Gasphasenabscheideverfahren handeln. Es kann dabei im Wesentlichen jedes Verfahren benutzt werden, mit welchem die jeweiligen Schichten der Wandlereinheiten ausgebildet werden können. Die Schichten der Wandlereinheiten können dabei Dicken von einigen Mikrometern aufweisen. Derartige Verfahren werden beispielsweise in der Halbleitertechnik angewendet.

Von Vorteil ist es, wenn die Trägerschicht, die zumindest eine Elektrodenschicht und/oder die Piezoschicht vollflächig auf dem Träger ausgebildet wird. Dadurch wird das Herstellungsverfahren vereinfacht, da die entsprechenden Schichten über den ganzen Träger angeordnet werden.

Zusätzlich oder alternativ ist es vorteilhaft, wenn die Trägerschicht, die zumindest eine Elektrodenschicht und/oder die Piezoschicht zwischen den Wandlereinheiten zumindest teilweise entfernt wird, so dass die Wandlereinheiten zumindest teilweise voneinander getrennt werden. Dadurch können die Wandlereinheiten voneinander separiert werden. Beispielsweise kann lediglich die Trägerschicht zurückbleiben, so dass die Wandlereinheiten mit der Trägerschicht miteinander verbunden bleiben. Es kann auch zusätzlich oder alternativ zwischen zwei benachbarten Wandlereinheiten zumindest eine Elektrodenschicht bestehen bleiben, wenn die beiden Wandlereinheiten eine zusammenhängende Gruppe bilden. Die zurückbleibende Elektrodenschicht kann dann als gemeinsame Elektrode, beispielsweise als Masse, für die beiden Wandlereinheiten dienen.

Vorteilhaft ist es, wenn beim Trennen der Wandlereinheiten zumindest zwischen einigen Wandlereinheiten lediglich die Piezoschicht und zumindest eine Elektrodenschicht entfernt wird, so dass zwischen diesen Wandlereinheiten zumindest die Trägerschicht intakt bleibt, so dass diese eine zusammenhängende Gruppe bilden. Die Trägerschicht verbindet dadurch die Gruppe aus Wandlereinheiten und fixiert sie gegeneinander. Zusätzlich oder alternativ kann auch eine Elektrodenschicht der Gruppe aus Wandlereinheiten intakt bleiben, so dass diese beispielsweise die Masse, d.h. die Elektrode für das Bezugspotential, für die Gruppe aus Wandlereinheiten bilden kann.

Von Vorteil ist es, wenn die zumindest eine Elektrodenschicht, die zumindest eine Piezoschicht und/oder die Trägerschicht selektiv auf dem Träger ausgebildet wird, so dass zumindest teilweise voneinander separierte Wandlereinheiten ausgebildet werden. Dies kann beispielsweise mit einem Fotolithografieverfahren, wie es in der Halbleiter- bzw. Dünnschichttechnik angewendet wird, durchgeführt werden. Es kann beispielsweise eine Maske verwendet werden, mittels der ein Muster auf den Träger ausgebildet wird. Auf das Muster werden dann die Schichten ausgebildet.

Vorteilhaft ist es, wenn die zumindest eine Elektrodenschicht, die Piezoschicht und/oder die Trägerschicht mittels Ätzen und/oder Schneiden entfernt wird. Dadurch können die Wandlereinheiten gezielt voneinander getrennt werden.

Von Vorteil ist es, wenn zum Entfernen des Trägers von den Wandlereinheiten eine Verbindung zwischen dem Träger und der Trägerschicht getrennt wird. Dies kann beispielsweise mechanisch durchgeführt werden. Die Trägerschicht kann zusätzlich oder alternativ auch chemisch vom Träger abgetrennt werden. Dadurch kann die Verbindung zwischen Träger und Trägerschicht gelöst oder zumindest geschwächt werden, so dass die Wandlereinheiten abgetrennt werden können. Dies hat den Vorteil, dass der Träger dabei intakt bleibt. Der Träger kann beispielsweise als ein Siliziumwafer ausgebildet sein, der teuer ist, so dass durch das Auftrennen der Verbindung zwischen dem Träger und der Trägerschicht der Träger wiederverwendet werden kann.

Zusätzlich oder alternativ kann der Träger abgeschliffen und/oder aufgelöst werden. Dies kann sich anbieten, wenn der Träger kostengünstig ist.

Zusätzlich oder alternativ kann die Trägerschicht auch, beispielsweise chemisch, aufgelöst werden, so dass die Verbindung zwischen Träger und Wandlereinheiten getrennt wird.

Vorteilhaft ist es, wenn die zumindest eine Wandlereinheit auf einer teilausgehärteten Membran angeordnet wird. Dabei kann es sich um eine B-Stage Membran handeln. Die Membran ist dabei selbst noch klebefähig. Zusätzlich oder alternativ kann die Membran danach vollständig ausgehärtet werden, so dass sich die Wandlereinheit stoffschlüssig mit der Membran verbindet. Das Aushärten kann dabei durch eine Wärmezufuhr unterstützt werden. Dadurch können auf einfache Weise die Wandlereinheiten mit der Membran verbunden werden.

Von Vorteil ist es, wenn die Membran aus einem Polymer ausgebildet wird. Als Polymer kann beispielsweise Silikon, Poly(p-xylylene) und/oder Parylene verwendet werden, welche eine hohe Flexibilität aufweisen. Zusätzlich oder alternativ kann die Membran mit einem Verstärkungsmittel, beispielsweise Silsesquioxane, verstärkt werden. Mit Hilfe der Verstärkungsmittel kann beispielsweise die Temperaturfestigkeit der Membran erhöht werden, so dass die Membraneinheit ohne Beschädigung beispielsweise verlötet werden kann.

Vorteilhaft ist es, wenn die Membran auf einem Membranträger ausgebildet wird. Die Membran kann auf dem Membranträger abgeschieden werden. Dies kann vorteilhaft sein, um eine bedarfsgerechte Membran bereitzustellen. Zusätzlich oder alternativ kann die Membran auch auf einer Rolle bereitgestellt werden. Dadurch steht die Membran im Wesentlichen unbegrenzt zur Verfügung. Die Membran kann dabei nach Bedarf von der Rolle abgerollt werden.

Von Vorteil ist es, wenn nach dem Entfernen des Trägers von den Wandlereinheiten diese zwischengelagert werden. Die Wandlereinheiten können beispielsweise mit Hilfe eines Roboters aufgenommen und auf einem Lagerelement abgelegt und dadurch zwischengespeichert werden. Mit Hilfe des Lagerelements können die Wandlereinheiten zu einem Weiterverarbeitungsort transportiert oder für eine spätere Verarbeitung zwischengelagert werden.

Mit der Membran werden mehrere Membraneinheiten ausgebildet. Dadurch können Herstellungskosten gesenkt werden. Es können beispielsweise auf einer entsprechend großen Membran mehrere Wandlereinheiten, einzeln oder gruppenweise, angeordnet werden, die die Membraneinheiten bilden.

Zusätzlich oder alternativ wird die Membran im Bereich zwischen zwei Membraneinheiten getrennt. Dadurch können die Membraneinheiten, mit einer oder mehreren Wandlereinheiten, vereinzelt werden.

Von Vorteil ist es, wenn in der zumindest einen Elektrodenschicht, Piezoschicht und/oder Trägerschicht zumindest eine Aussparung ausgebildet wird, so dass eine elektrische Verbindung zu der zumindest einen Elektrodenschicht ausgebildet werden kann. Die Aussparung kann auch als Durchkontaktierung ausgebildet sein, in der eine elektrische Leitung angeordnet werden kann, um das elektrische Signal zum Erzeugen von Schall zur Piezoschicht zu führen und/oder um das erzeugte elektrische Signal beim Erfassen von Schall von der Piezoschicht weg zu führen.

Vorteilhaft ist es, wenn die Wandlereinheit und/oder die Membraneinheit für die elektrische Verbindung zur zumindest einen Elektrodenschicht mit zumindest einem elektrisch leitfähigen Leiter versehen wird. Der Leiter kann als Leiterschicht ausgebildet werden, die mittels eines Druckverfahrens, Abscheideverfahrens und/oder Beschichtungsverfahrens aufgedruckt wird.

Das vorgeschlagene Verfahren dient der Herstellung einer Membraneinheit mit einer Membran und zumindest einer damit verbundenen Wandlereinheit, die zumindest eine Elektrodenschicht und zumindest eine Piezoschicht umfasst. Mit Hilfe der Piezoschicht kann ein elektrisches Signal, welches beispielsweise ein Audiosignal umfassen kann, in eine Auslenkung umgesetzt werden. Diese Auslenkung kann auf die Membran übertragen werden, um beispielsweise, insbesondere, hörbaren Schall zu erzeugen. Die Membraneinheit kann somit als Lautsprecher betrieben werden. Zusätzlich oder alternativ kann ein Schall auch die Membran zum Schwingen anregen, was zu einer Auslenkung der Membran führt. Diese Auslenkung kann auf die Piezoschicht übertragen werden, welche weiterhin ein elektrisches Signal erzeugt. Das elektrische Signal kann ein Audiosignal enthalten, so dass die Membraneinheit als Mikrofon betrieben werden kann.

Die Membraneinheit kann dabei gemäß zumindest einem Verfahrensmerkmal der vorangegangenen und/oder nachfolgenden Beschreibung ausgebildet sein.

Die Wandlereinheiten können ferner in nahezu beliebigen Formen, Geometrien und/oder Anordnungen auf der Membran angeordnet sein. Beispielsweise können die drei Wandlereinheiten in einem Dreieck auf der Membran angeordnet werden, so dass die Membraneinheit drei Wandlereinheiten umfasst, die in einem Dreieck angeordnet sind.

Weitere Vorteile der Erfindung sind in den nachfolgenden Ausführungsbeispielen beschrieben. Es zeigen:
- **Figur 1**: eine schematische Seitenansicht mehrerer schichtweise aufgebauter Wandlereinheiten,
- **Figur 2**: eine schematische Seitenansicht mehrerer getrennt voneinander ausgebildeter Wandlereinheiten,
- **Figur 3**: eine schematische Seitenansicht mehrerer Wandlereinheiten,
- **Figur 4**: eine schematische Seitenansicht mehrerer Wandlereinheiten, wobei der Träger entfernt ist,
- **Figur 5**: eine schematische Seitenansicht mehrerer Wandlereinheiten auf einer Membran,
- **Figur 6**: eine schematische Draufsicht auf mehrere Wandlereinheiten auf einer Membran und
- **Figur 7**: eine schematische Draufsicht auf mehrere Membraneinheiten.

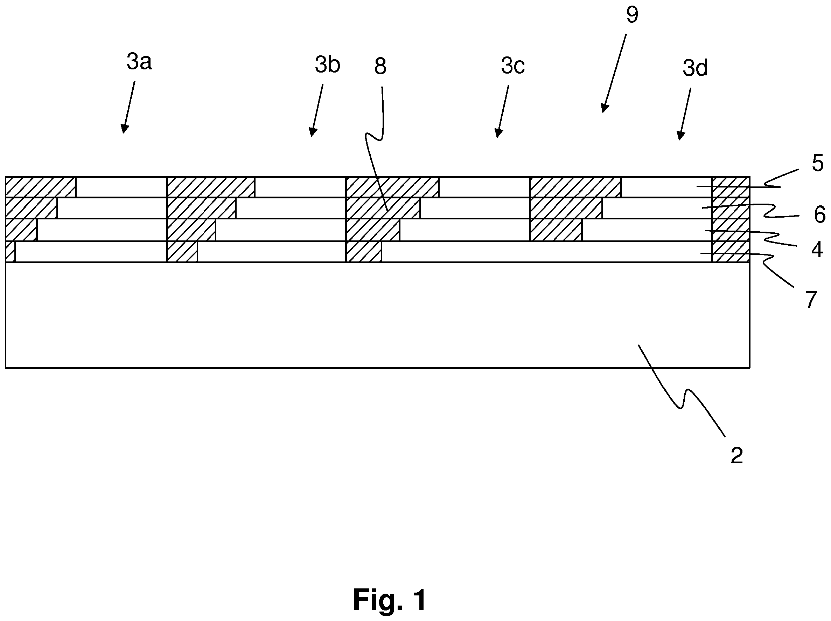

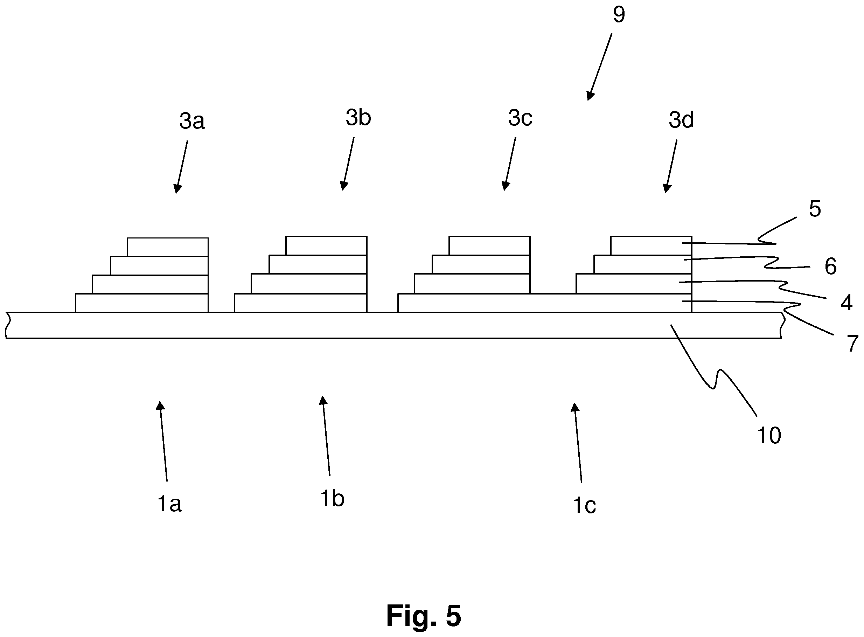

Figur 1 zeigt eine schematische Seitenansicht mehrerer schichtweise aufgebauter, piezoelektrischer Wandlereinheiten 3a - 3d. Im vorliegenden Ausführungsbeispiel sind vier Wandlereinheiten 3a - 3d gezeigt, wobei die Figur 1 lediglich ein Ausschnitt sein kann. Die Wandlereinheiten 3a - 3d sind auf einem Träger 2 angeordnet. Auf dem Träger 2 können zur Massenherstellung bis zu 1000 oder noch mehr Wandlereinheiten 3a - 3d ausgebildet sein. Die Wandlereinheiten 3a - 3d bilden zusammen mit einer Membran 10 Membraneinheiten 1 (vgl. ab Figur 5), die für MEMS-Wandler verwendet werden können.

Zu beachten ist bei den Figuren, dass es sich um schematische Ansichten handelt. Die Größenordnungen und -verhältnisse müssen nicht mit der Realität übereinstimmen. Außerdem wird anhand der Figuren lediglich das Herstellungsverfahren mit den einzelnen Schritten erklärt werden. Die gegenseitige Anordnung der verschiedenen Merkmale muss nicht, kann jedoch, mit der Realität übereinstimmen.

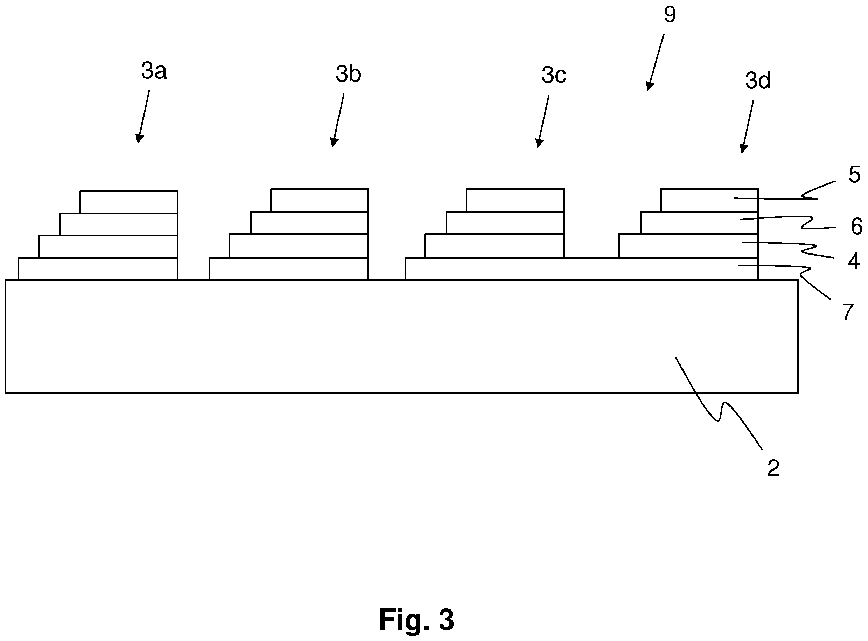

Beim Herstellungsverfahren der Wandlereinheiten 3a - 3d werden auf dem Träger 2 zumindest eine Elektrodenschicht 4, 5 und zumindest eine Piezoschicht 6 ausgebildet. Die Wandlereinheiten 3a - 3d umfassen somit zumindest die zumindest eine Elektrodenschicht 4, 5 und die zumindest eine Piezoschicht 6. Gemäß dem vorliegenden Ausführungsbeispiel werden die zumindest eine Elektrodenschicht 4, 5 und die zumindest eine Piezoschicht 6 vollflächig auf dem Träger 2 ausgebildet. Die hier gezeigten schraffierten Bereiche der zumindest einen Elektrodenschicht 4, 5 und der zumindest einen Piezoschicht 6 können in einem Verfahrensschritt entfernt werden, so dass die Wandlereinheiten 3a - 3d voneinander getrennt werden. Der schraffierte Bereich kann beispielsweise ein Ätzbereich 8 sein. Der Ätzbereich 8 kann beispielsweise mittels eines Ätzverfahrens, wie es in der Halbleitertechnik verwendet wird, entfernt werden. Die voneinander getrennten Wandlereinheiten 3a - 3d sind beispielsweise in Figur 3 gezeigt.

Mit Hilfe der Piezoschicht 6 kann ein elektrisches Signal, welches beispielsweise ein Audiosignal umfasst, in eine Auslenkung umgesetzt werden. Wenn die Piezoschicht 6 mit dem elektrischen Signal beaufschlagt wird, lenkt sich die Piezoschicht 6 selbst aus. Diese Auslenkung kann in Schall umgesetzt werden, der Töne, Musik und/oder Sprache entsprechend des Audiosignals umfassen kann. Die Wandlereinheiten 3a - 3d können somit dazu verwendet werden, einen Lautsprecher auszubilden.

Zusätzlich oder alternativ kann mit Hilfe der Piezoschicht 6 auch eine Auslenkung in ein elektrisches Signal umgesetzt werden. Trifft Schall auf eine Wandlereinheit 3a - 3d kann die Piezoschicht 6 selbst ausgelenkt werden. Die Piezoschicht 6 setzt diese Auslenkung in ein elektrisches Signal um, welches Informationen über den Schall enthält. Die Wandlereinheiten 3a - 3d können somit dazu verwendet werden, ein Mikrofon auszubilden. Die Wandlereinheiten 3a - 3d können somit beispielsweise in einem Smartphone oder einem ähnlichen Gerät angeordnet werden.

Zusätzlich oder alternativ können die Wandlereinheiten 3a - 3d auch für mechanische Systeme verwendet werden. Die Wandlereinheiten 3a - 3d können beispielsweise in Mikropumpen verwendet werden, da mit Hilfe der Auslenkung der Piezoschicht 6 auch ein Fluid gepumpt werden kann.

Die Piezoschicht 6 ist dabei aus einem piezoelektrischen Material ausgebildet, welches den Piezoeffekt aufweist.

Mit Hilfe der zumindest einen Elektrodenschicht 4, 5 kann das elektrische Signal zur Piezoschicht 6 geführt werden, um die Piezoschicht 6 auszulenken. Zusätzlich oder alternativ kann das elektrische Signal mit Hilfe der zumindest einen Elektrodenschicht 4, 5 auch weggeführt werden, wenn die Piezoschicht 6 selbst ausgelenkt wird und das elektrische Signal erzeugt. Die zumindest eine Elektrodenschicht 4, 5 ist dabei vorteilhafterweise aus einem elektrisch leitfähigen Material ausgebildet.

Gemäß dem vorliegenden Ausführungsbeispiel umfassen die Wandlereinheiten 3a - 3d eine erste Elektrodenschicht 4 und eine zweite Elektrodenschicht 5. Dadurch kann ein Stromkreis geschlossen werden. Die Piezoschicht 6 ist im vorliegenden Ausführungsbeispiel zwischen den beiden Elektrodenschichten 4, 5 angeordnet.

Gemäß dem vorliegenden Ausführungsbeispiel wird beim Herstellungsverfahren auf dem Träger 2 eine Trägerschicht 7 ausgebildet. Die Trägerschicht 7 kann als Epitaxieschicht ausgebildet sein. Die Trägerschicht 7 kann als Opferschicht dienen, die beim Entfernen des Trägers 2 von den Wandlereinheiten 3a - 3d entfernt wird. Der Träger 2 kann dadurch einfacher von den Wandlereinheiten 3a - 3d abgetrennt werden, wenn die Trägerschicht 7 beispielsweise zumindest teilweise, insbesondere chemisch, aufgelöst und/oder entfernt wird.

Gemäß dem vorliegenden Ausführungsbeispiel wird die Trägerschicht 7 lediglich teilweise, gemäß den schraffierten Bereichen, entfernt. Gemäß dem vorliegenden Ausführungsbeispiel bildet die Trägerschicht 7 einen Teil der Wandlereinheiten 3a - 3d. Dadurch kann die Trägerschicht 7 beispielsweise als Gegenstück für die Piezoschicht 6 dienen. Die Trägerschicht 7 kann eine höhere Steifigkeit als die Piezoschicht 6 aufweisen, so dass sich die Piezoschicht 6 gegen die Trägerschicht 7 auslenken kann.

Gemäß dem vorliegenden Ausführungsbeispiel sind die Trägerschicht 7, die zumindest eine Elektrodenschicht 4, 5 und/oder die Piezoschicht 6 übereinander angeordnet. Auf dem Träger 2 ist zuerst die Trägerschicht 7 ausgebildet. Auf dieser ist die erste Elektrodenschicht 4 ausgebildet. Auf der ersten Elektrodenschicht 4 ist die Piezoschicht 6 ausgebildet. Auf der Piezoschicht 6 ist die zweite Elektrodenschicht 5 ausgebildet. Alternativ kann auch die zumindest eine Elektrodenschicht 4, 5 auf dem Träger 2 ausgebildet werden.

Die schraffierten Bereiche können beispielsweise mittels eines Ätzverfahrens entfernt werden. Dadurch werden die Wandlereinheiten 3a - 3d voneinander getrennt. Gemäß dem vorliegenden Ausführungsbeispiel wird zwischen den beiden Wandlereinheiten 3a, 3b und den beiden Wandlereinheiten 3b, 3c die Trägerschicht 7, die zumindest eine Elektrodenschicht 4, 5 und die Piezoschicht 6 entfernt. Zwischen den beiden Wandlereinheiten 3c, 3d wird lediglich die zumindest eine Elektrodenschicht 4, 5 und die zumindest eine Piezoschicht 6 entfernt, so dass die Trägerschicht 7 intakt bleibt. Dadurch sind die beiden Wandlereinheiten 3c, 3d mittels der Trägerschicht 7 miteinander verbunden, so dass diese beiden Wandlereinheiten 3c, 3d eine zusammenhängende Gruppe 9 ausbilden. Die beiden Wandlereinheiten 3a, 3b bilden dagegen einzelne Wandlereinheiten 3a, 3b. In einem alternativen, hier nicht gezeigten, Ausführungsbeispiel könnte zwischen den beiden Wandlereinheiten 3c, 3d auch zumindest eine Elektrodenschicht 4, 5, vorzugsweise die unterste bzw. die erste Elektrodenschicht 4, intakt bleiben. Mit dieser Elektrodenschicht 4, 5 kann eine Masse bzw. ein Bezugspotential für beide Wandlereinheiten 3c, 3d ausgebildet werden.

Die Elektrodenschichten 4, 5, die Piezoschicht 6 und die Trägerschicht 7 sind hier und in den folgenden Figuren der Einfachheit und Übersichtlichkeit wegen lediglich mit einem einzigen Bezugszeichen versehen. Die besagten Schichten 4 - 7 sind genaugenommen entsprechend der voneinander getrennten Wandlereinheiten 3a - 3d ebenfalls voneinander getrennt. Die Orientierung der besagten Schichten 4 - 7 ist jedoch vorteilhafterweise bei allen Wandlereinheiten 3a - 3d stets gleich. Insbesondere erstreckt sich jede Schicht 4 - 7 in einer Ebene, die parallel zum Träger 2 angeordnet sein kann, über den Träger 2. Sofern nichts anderes beschrieben ist, ist die Reihenfolge der Schichten 4 - 7 stets die gleiche.

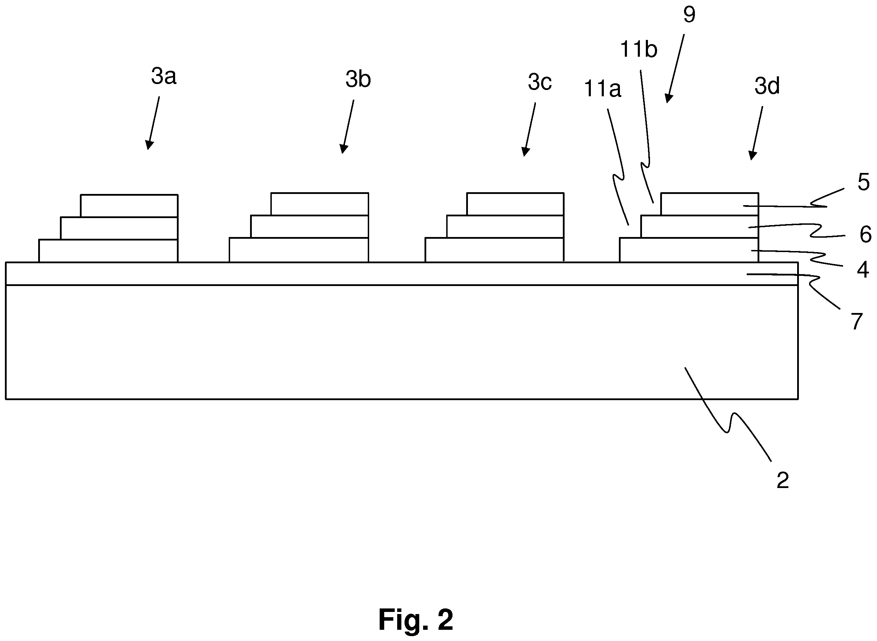

Figur 2 zeigt ein alternatives Herstellungsverfahren einer Membraneinheit 1 mit mehreren Wandlereinheiten 3a - 3d. Jedoch werden Merkmale, die bereits in der vorangegangenen Figur beschrieben sind, der Einfachheit halber nicht nochmals erklärt, wenn sie die gleiche oder eine ähnliche Wirkung aufweisen.

Gemäß dem vorliegenden Ausführungsbeispiel sind die Wandlereinheiten 3a - 3d zumindest teilweise voneinander getrennt. Die zumindest eine Elektrodenschicht 4, 5 und die zumindest eine Piezoschicht 6 sind bereits voneinander getrennt ausgebildet, so dass die einzelnen Wandlereinheiten 3a - 3d ausgebildet werden können. Gemäß dem vorliegenden Ausführungsbeispiel ist lediglich die Trägerschicht 7 vollflächig auf dem Träger 2 ausgebildet. Zum zumindest teilweisen Trennen der Wandlereinheiten 3a - 3d voneinander, muss noch die Trägerschicht 7 zwischen zumindest einigen Wandlereinheiten 3a - 3d entfernt werden. Das hier gezeigte selektive Ausbilden der zumindest einen Elektrodenschicht 4, 5, der Piezoschicht 6 und/oder der Trägerschicht 7 kann beispielsweise mittels Fotolithografie ausgebildet werden.

Des Weiteren weist gemäß dem vorliegenden Ausführungsbeispiel zumindest eine Wandlereinheit 3a - 3d zumindest eine Aussparung 11a, 11b auf. Der Einfachheit halber ist die zumindest eine Aussparung 11a, 11b lediglich an einer Wandlereinheit 3d mit einem Bezugszeichen versehen. Mit Hilfe der zumindest einen Aussparung 11a, 11b kann beispielsweise eine elektrische Verbindung zu zumindest einer Elektrodenschicht 4, 5 ausgebildet werden, um ein elektrisches Signal zu dieser Elektrodenschicht 4, 5 zu führen oder von dieser abzuleiten. Gemäß dem vorliegenden Ausführungsbeispiel weist zumindest die Piezoschicht 6 die erste Aussparung 11a auf, so dass die darunterliegende erste Elektrodenschicht 4 zumindest teilweise freigelegt ist. In die erste Aussparung 11a kann ein hier nicht gezeigter elektrischer Leiter angeordnet werden, der eine Verbindung zur ersten Elektrodenschicht 4 ausbilden kann. Zusätzlich oder alternativ weist die zweite Elektrodenschicht 5 die zweite Aussparung 11b auf. Die Aussparung 11a, 11b kann auch als Durchkontaktierung, beispielsweise in der zumindest einen Elektrodenschicht 4, 5, der Piezoschicht 6 und/oder der Trägerschicht 7, ausgebildet sein, so dass eine elektrische Verbindung zu zumindest einer Elektrodenschicht 4, 5 ausgebildet werden kann.

Figur 3 zeigt eine schematische Seitenansicht mehrerer Wandlereinheiten 3a - 3d. Merkmale, die bereits in den vorangegangenen Figuren beschrieben sind, werden der Einfachheit halber nicht nochmals erklärt.

Gemäß dem vorliegenden Ausführungsbeispiel sind die Wandlereinheiten 3a - 3d zumindest teilweise voneinander getrennt. Zwischen der Wandlereinheit 3a und der Wandlereinheit 3b sowie zwischen der Wandlereinheit 3b und der Wandlereinheit 3c ist neben der zumindest einen Elektrodenschicht 4, 5 und der Piezoschicht 6 auch die Trägerschicht 7 entfernt, wodurch die besagten Wandlereinheiten 3a - 3c voneinander getrennt sind. Alle Wandlereinheiten 3a - 3d sind jedoch noch auf dem Träger 2 angeordnet.

Zwischen der Wandlereinheit 3c und der Wandlereinheit 3d ist die Trägerschicht 7 noch intakt, so dass diese beiden Wandlereinheiten 3c, 3d über die Trägerschicht 7 noch miteinander verbunden sind. Die beiden Wandlereinheiten 3c, 3d bilden somit die zusammenhängende Gruppe 9.

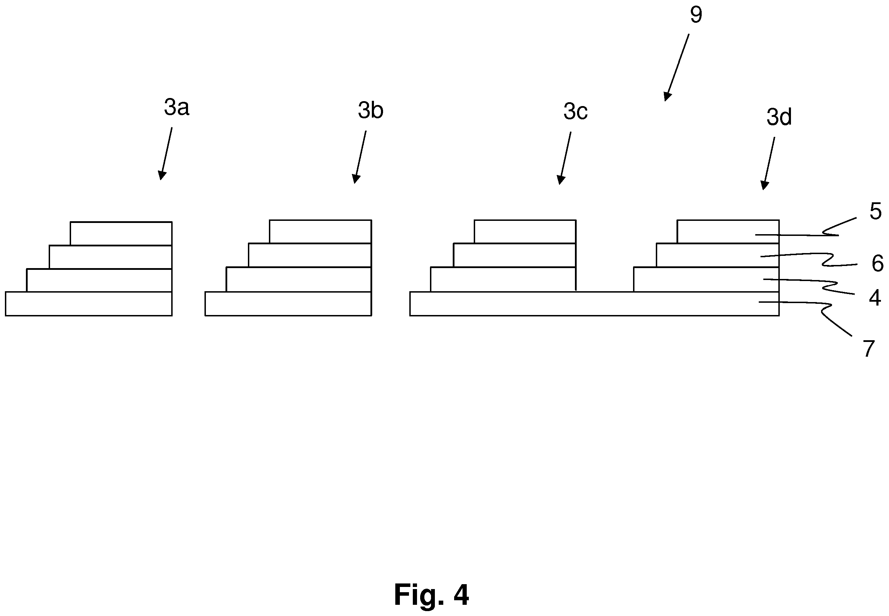

Figur 4 zeigt eine schematische Seitenansicht mehrerer Wandlereinheiten 3a - 3d, wobei der Träger 2 entfernt ist. Merkmale, die bereits in den vorangegangenen Figuren beschrieben sind, werden der Einfachheit halber nicht nochmals erklärt. Das hier gezeigte Ausführungsbeispiel weist zwei einzelne Wandlereinheiten 3a, 3b und eine zusammenhängende Gruppe 9 aus zwei Wandlereinheiten 3c, 3d auf.

Eine zusammenhängende Gruppe 9 umfasst zumindest zwei Wandlereinheiten 3a - 3d. Zusätzlich oder alternativ kann diese oder eine andere zusammenhängende Gruppe 9 auch mehr als zwei Wandlereinheiten 3a - 3d umfassen. Ferner sind gemäß dem vorliegenden Ausführungsbeispiel die beiden Wandlereinheiten 3c, 3d der zusammenhängenden Gruppe 9 lediglich translatorisch zueinander versetzt angeordnet. Beide Wandlereinheiten 3c, 3d weisen jedoch die gleiche Orientierung zueinander auf. In einem alternativen Ausführungsbeispiel können auch zumindest zwei Wandlereinheiten 3a - 3d zueinander verdreht sein. Beispielsweise können zumindest zwei Wandlereinheiten 3a - 3d entgegengesetzt zueinander orientiert sein. Ferner sind gemäß dem vorliegenden Ausführungsbeispiel die Wandlereinheiten 3a - 3d hintereinander angeordnet gezeigt. Die Wandlereinheiten 3a - 3d können zusätzlich oder alternativ auch flächig auf dem Träger 2 angeordnet werden, so dass die Wandlereinheiten 3a - 3d zusätzlich zu hintereinander auch nebeneinander angeordnet sind. Die Wandlereinheiten 3a - 3d können auch nur nebeneinander angeordnet sein.

Ferner ist der Träger 2 von den Wandlereinheiten 3a - 3d entfernt. Beispielsweise kann dies dadurch erreicht werden, dass eine Verbindung zwischen dem Träger 2 und der ersten Schicht, was hier die Trägerschicht 7 ist bzw. war, gelöst wird. Dies kann beispielsweise mit Hilfe eines chemischen Verfahrens durchgeführt werden. Beispielsweise kann gemäß dem vorliegenden Ausführungsbeispiel die Trägerschicht 7 zumindest teilweise chemisch aufgelöst werden. In diesem Fall kann die Trägerschicht 7 entsprechend dicker ausgebildet werden, so dass nach dem teilweisen Auflösen die Trägerschicht 7 noch vorhanden bleibt. Das Lösen der Verbindung zwischen dem Träger 2 und der ersten Schicht, was hier die Trägerschicht 7 ist, kann vorteilhaft sein, wenn der Träger 2 kostspielig ist und wiederverwendet werden soll. Beim Träger 2 kann es sich beispielsweise um einen Siliziumwafer handeln, der verhältnismäßig teuer in der Anschaffung ist und wiederverwendet werden soll.

Zusätzlich oder alternativ kann der Träger 2 auch abgeschliffen werden, bis die Wandlereinheiten 3a - 3d übrig bleiben. Dies kann dann vorteilhaft sein, wenn der Träger 2 ohnehin zerstört werden würde und/oder wenn der Träger 2 aus einem kostengünstigen Material hergestellt ist.

Figur 5 zeigt mehrere Wandlereinheiten 3a - 3d auf der Membran 10. Merkmale, die bereits in den vorangegangenen Figuren beschrieben sind, werden der Einfachheit halber nicht nochmals erklärt. Bei der Membran 10 kann es sich um eine Polymerschicht handeln. Die Membran 10 kann beispielsweise aus einem flexiblen Material wie beispielsweise Poly(p-xylylene) oder Parylene ausgebildet sein. Eine Dicke der Membran 10 kann im Bereich von einigen Mikrometern, beispielsweise 5 - 7 µm, liegen. Die Dicke der Membran 10 beträgt mindestens 0,01 µm. Die Wandlereinheiten 3a - 3d bilden mit der Membran 10 gemäß dem vorliegenden Ausführungsbeispiel drei Membraneinheiten 1a - 1c. Die ersten Wandlereinheit 3a und die zweite Wandlereinheit 3b bilden jeweils eine Membraneinheit 1a und 1b. Die beiden anderen Wandlereinheiten 3c, 3d bilden zusammen die zusammenhängende Gruppe 9. Die zusammenhängende Gruppe 9 mit den beiden Wandlereinheiten 3c, 3d bildet eine einzige Membraneinheit 1c. Diese Membraneinheit 1c umfasst somit eine Membran 10 mit zwei zur zusammenhängenden Gruppe 9 zusammengefassten Wandlereinheiten 3c, 3d. Mit den beiden Wandlereinheiten 3c, 3d kann die Membran 10 beispielsweise stärker ausgelenkt werden, so dass ein Schalldruck erhöht werden kann, wenn die Membraneinheit 1c dazu verwendet wird, Schall zu erzeugen.

Gemäß dem vorliegenden Ausführungsbeispiel sind die Membraneinheiten 1a - 1c noch mittels der Membran 10 miteinander verbunden. In einem späteren Schritt, kann die Membran 10 zwischen den Membraneinheiten 1a - 1c getrennt werden, um die Membraneinheiten 1a - 1c zu vereinzeln.

Bevor die Wandlereinheiten 3a - 3d auf die Membran 10 angeordnet werden, kann sie noch mittels Verstärkungsmitteln verstärkt werden. Als Verstärkungsmittel kann beispielsweise Silsesquioxane verwendet werden, welche die Temperaturbeständigkeit der Membran 10 verbessern. Dadurch können die Membraneinheiten 1 beispielsweise verlötet werden.

Die Membran 10 kann auch eine teilausgehärtete Membran sein, so dass beim Anordnen der Wandlereinheiten 3a - 3d auf der Membran 10 die Verbindung zwischen den Wandlereinheiten 3a - 3d und der Membran 10 ausgebildet werden kann. Die teilausgehärtete Membran kann, beispielsweise unter Wärmezufuhr, ausgehärtet werden, so dass zwischen den Wandlereinheiten 3a - 3d und der Membran 10 stoffschlüssige Verbindungen ausgebildet werden.

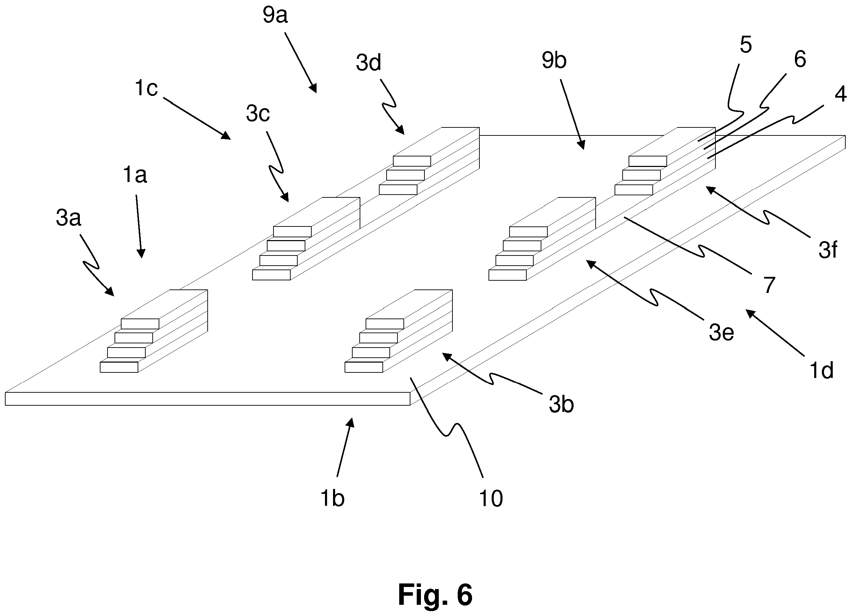

Figur 6 zeigt eine schematisch, perspektivische Ansicht auf mehrere Wandlereinheiten 3a - 3f auf einer Membran 10. Merkmale, die bereits in den vorangegangenen Figuren beschrieben sind, werden der Einfachheit halber nicht nochmals erklärt. Im vorliegenden Ausführungsbeispiel sind sechs Wandlereinheiten 3a - 3f auf der Membran 10 angeordnet. Dabei handelt es sich um zwei einzelne Wandlereinheiten 3a, 3b und um zwei zusammenhängende Gruppen 9a, 9b mit jeweils zwei Wandlereinheiten 3c - 3f. Die beiden zusammenhängenden Gruppen 9a, 9b sind im vorliegenden Ausführungsbeispiel mittels der Trägerschicht 7 miteinander verbunden.

Durch das Abtrennen des Trägers 2 von den Wandlereinheiten 3a - 3f und der zumindest teilweisen Vereinzelung der Wandlereinheiten 3a - 3f ist eine freie Platzierung der Wandlereinheiten 3a - 3f auf der Membran 10 gegeben. Die Wandlereinheiten 3a - 3f können in nahezu beliebiger Anordnung und Zusammenstellung auf der Membran 10 angeordnet werden. Beispielsweise bildet die Wandlereinheit 3a mit der Membran 10 die erste Membraneinheit 1a. Diese umfasst lediglich eine Wandlereinheit 3a. Gleiches gilt für die zweite Membraneinheit 1b, die ebenfalls lediglich eine Wandlereinheit 3b aufweist. Die dritte Membraneinheit 1c umfasst die Membran 10 und zwei Wandlereinheiten 3c, 3d, die zur zusammenhängenden Gruppe 9a zusammengefasst sind. Mit Hilfe der zwei Wandlereinheiten 3c, 3d kann beispielsweise Schall mit einem höheren Schalldruck erzeugt werden, als mit nur einer Wandlereinheit 3a - 3f. Die vierte Membraneinheit 1d umfasst die Membran 10 und die beiden Wandlereinheiten 3e, 3f, die zur zusammenhängenden Gruppe 9b zusammengefasst sind.

Der Gestaltung der Membraneinheiten 1 sind keine Grenzen gesetzt. Beispielsweise können die Wandlereinheiten 3a - 3f in nahezu beliebiger Form auf der Membran 10 angeordnet werden. Beispielsweise können drei Wandlereinheiten 3a - 3f als Dreieck auf der Membran 10 angeordnet werden, wobei die drei Wandlereinheiten 3a - 3f und die Membran 10 eine Membraneinheit 1 bilden. Die Membran 10 wird nach dem Anordnen der Wandlereinheiten 3a - 3f entsprechend der Zusammenstellung zur Membraneinheit 1 getrennt, so dass die einzelnen Membraneinheiten 1 ausgebildet werden.

Um die einzelnen Membraneinheiten 1a - 1d auszubilden, wird die Membran 10 entsprechend der Zusammenstellung der Wandlereinheiten 3a - 3f zu den Membraneinheiten 1a - 1d getrennt, beispielsweise zerschnitten.

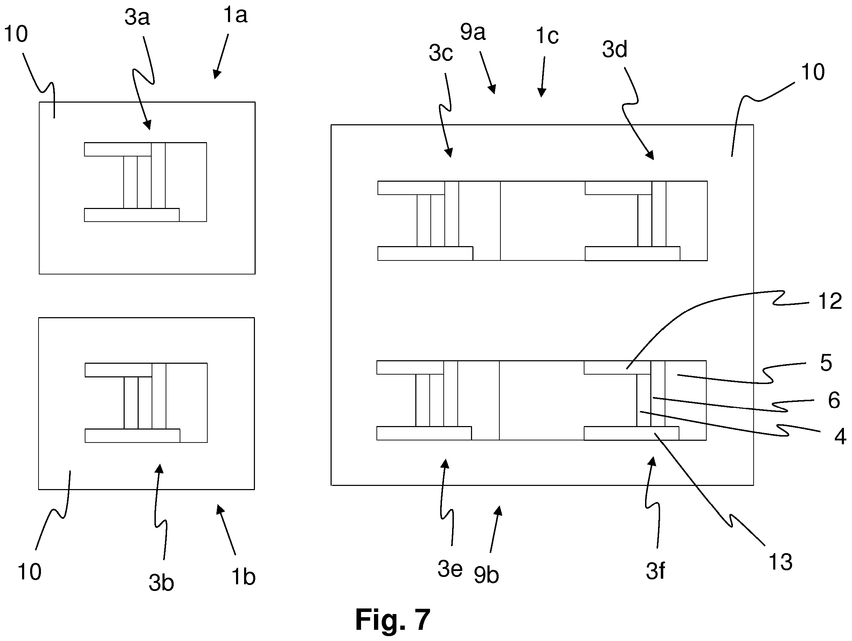

Figur 7 zeigt eine schematische Draufsicht auf mehrere Membraneinheiten 1a - 1c. Merkmale, die bereits in den vorangegangenen Figuren beschrieben sind, werden der Einfachheit halber nicht nochmals erklärt. Gemäß dem vorliegenden Ausführungsbeispiel ist die Membran 10 zumindest teilweise zwischen den Wandlereinheiten 3a - 3f und/oder zumindest teilweise zwischen den zusammenhängenden Gruppen 9a, 9b getrennt.

Im vorliegenden Ausführungsbeispiel ist die Membran 10 zwischen den beiden Wandlereinheiten 3a, 3b und zu den vier anderen Wandlereinheiten 3c - 3f getrennt. Die beiden Wandlereinheiten 3a, 3b bilden jeweils mit einem Ausschnitt der Membran 10 eine Membraneinheit 1a, 1b.

Die vier Wandlereinheiten 3c - 3f, wobei jeweils zwei Wandlereinheiten 3c, 3d und 3e, 3f zu den beiden zusammenhängenden Gruppen 9a, 9b zusammengefasst sind, bilden eine Membraneinheit 1c. Bei der sind jeweils zwei Wandlereinheiten 3c - 3f hintereinander und zwei Wandlereinheiten 3c - 3f nebeneinander angeordnet. Die Wandlereinheiten 3c - 3f der Membraneinheit 1c sind somit gemäß eines Rechtecks angeordnet.

Die Membran 10 kann zum Ausbilden der einzelnen Membraneinheiten 1a - 1c geteilt werden. Die Membran 10 kann beispielsweise zerschnitten werden, je nachdem welche und wieviel Wandlereinheiten 3a - 3f zu einer Membraneinheit 1a - 1c gehören.

Wenn zusätzlich die Membran 10 der Membraneinheit 1c zwischen den beiden zusammenhängenden Gruppen 9a, 9b getrennt werden würde, würden zwei Membraneinheiten 1 ähnlich zur Figur 6 ausgebildet.

Des Weiteren weisen die Wandlereinheiten 3a - 3f noch zumindest einen Leiter 12, 13 auf. Der zumindest eine Leiter 12, 13 kann beispielsweise als Leiterschicht ausgebildet sein, die beispielsweise auf die Wandlereinheiten 3a - 3f und/oder auf die Membraneinheiten 1a - 1c aufgedruckt ist. Gemäß dem vorliegenden Ausführungsbeispiel weisen die Wandlereinheiten 3a - 3f einen ersten und einen zweiten Leiter 12, 13 auf. Der erste Leiter 12 ist mit der ersten Elektrodenschicht 4 und der zweite Leiter 13 ist mit der zweiten Elektrodenschicht 5 verbunden. Mittels des zumindest einen elektrischen Leiters 12, 13 kann die elektrische Verbindung zu der zumindest einen Elektrodenschicht 4, 5 ausgebildet werden. Hier ist der zumindest eine Leiter wieder nur an einer Wandlereinheit 3f mit einem Bezugszeichen versehen. Die anderen Wandlereinheiten 3a - 3e können, wie hier schematisch gezeigt ist, ebenfalls zumindest einen Leiter 12, 13 aufweisen.

Wenn eine Membraneinheit 1c mehrere Wandlereinheiten 3c - 3f aufweist, kann der zumindest eine Leiter 12, 13 der jeweiligen Wandlereinheiten 3c-3f auch miteinander verbunden sein, so dass das elektrische Signal zu allen Wandlereinheiten 3c - 3f geführt wird und/oder von diesen abgeführt wird. Die Wandlereinheiten 3c - 3f der Membraneinheit 1c sind dadurch elektrisch miteinander verbunden.

Zusätzlich oder alternativ kann der zumindest eine elektrische Leiter 12, 13 auch in und/oder auf der Membran 10 angeordnet sein. Die elektrische Verbindung zwischen dem zumindest einen elektrischen Leiter 12, 13 und der zumindest einen Elektrodenschicht 4, 5 wird dann ausgebildet, wenn die Wandlereinheiten 3a - 3f auf die Membran 10 angeordnet werden.

Die vorliegende Erfindung ist nicht auf die dargestellten und beschriebenen Ausführungsbeispiele beschränkt. Abwandlungen im Rahmen der Patentansprüche sind ebenso möglich wie eine Kombination der Merkmale, auch wenn diese in unterschiedlichen Ausführungsbeispielen dargestellt und beschrieben sind. Der Gegenstand der Erfindung wird durch die nachfolgenden Ansprüche definiert.

### Bezugszeichenliste

- 1: Membraneinheit
- 2: Träger
- 3: Wandlereinheit
- 4: erste Elektrodenschicht
- 5: zweite Elektrodenschicht
- 6: Piezoschicht
- 7: Trägerschicht
- 8: Ätzbereich
- 9: zusammenhängende Gruppe
- 10: Membran
- 11: Aussparung
- 12: erster Leiter
- 13: zweiter Leiter

## Patentansprüche

1. Herstellungsverfahren für zumindest eine Membraneinheit (1) eines MEMS-Wandlers,
bei dem auf einem Träger (2) mehrere piezoelektrische Wandlereinheiten (3) mit jeweils zumindest einer Elektrodenschicht (4, 5) und zumindest einer Piezoschicht (6) ausgebildet werden,
**dadurch gekennzeichnet,**
**dass** der Träger (2) von den Wandlereinheiten (3) entfernt wird, dass zumindest eine der Wandlereinheiten (3) zur Ausbildung der zumindest einen Membraneinheit (1) auf einer Membran (10) angeordnet und mit dieser verbunden wird und
**dass** mit der Membran (10) mehrere Membraneinheiten (1) ausgebildet werden und/oder
**dass** die Membran (10) im Bereich zwischen zwei Membraneinheiten (1) getrennt wird.

2. Herstellungsverfahren nach dem vorherigen Anspruch, wobei
die Wandlereinheiten (3) voneinander getrennt auf dem Träger (2) ausgebildet werden und/oder
dass die Wandlereinheiten (3) vor oder nach dem Entfernen des Trägers (2) voneinander getrennt werden.

3. Herstellungsverfahren nach einem oder mehreren der vorherigen Ansprüche, wobei
die Wandlereinheiten (3) derart voneinander getrennt ausgebildet und/oder voneinander getrennt werden, dass zumindest eine vereinzelte Wandlereinheit (3) und/oder zumindest eine zusammenhängende Gruppe (9) von zumindest zwei Wandlereinheiten (3) ausgebildet wird.

4. Herstellungsverfahren nach einem oder mehreren der vorherigen Ansprüche, wobei auf dem Träger (2) eine Trägerschicht (7) ausgebildet wird, auf der die zumindest eine Elektrodenschicht (4, 5) und die zumindest eine Piezoschicht (6) der Wandlereinheiten (3) ausgebildet werden, und/oder
dass die zumindest eine Elektrodenschicht (4, 5), die zumindest eine Piezoschicht (6) und/oder die Trägerschicht (7) übereinander auf dem Träger (2) ausgebildet werden.

5. Herstellungsverfahren nach einem oder mehreren der vorherigen Ansprüche, wobei
eine erste und eine zweite Elektrodenschicht (4, 5) auf dem Träger (2) ausgebildet werden und/oder
dass die Piezoschicht (6) zwischen der ersten und der zweiten Elektrodenschicht (4, 5) ausgebildet wird.

6. Herstellungsverfahren nach einem oder mehreren der vorherigen Ansprüche, wobei zuerst die erste Elektrodenschicht (4), dann die Piezoschicht (6) und dann die zweite Elektrodenschicht (5) und/oder zuvor die Trägerschicht (7) ausgebildet wird.

7. Herstellungsverfahren nach einem oder mehreren der vorherigen Ansprüche, wobei die Trägerschicht (7), die zumindest eine Elektrodenschicht (4, 5) und/oder die Piezoschicht (6) vollflächig auf dem Träger (2) ausgebildet wird und/oder
dass die Trägerschicht (7), die zumindest eine Elektrodenschicht (4, 5) und/oder die Piezoschicht (6) zwischen den Wandlereinheiten (3) zumindest teilweise entfernt wird, so dass die Wandlereinheiten (3) zumindest teilweise voneinander getrennt werden.

8. Herstellungsverfahren nach einem oder mehreren der vorherigen Ansprüche, wobei beim Trennen der Wandlereinheiten (3) zumindest zwischen einigen Wandlereinheiten (3) lediglich die Piezoschicht (6) und zumindest eine Elektrodenschicht (4, 5) entfernt wird, so dass zwischen diesen Wandlereinheiten (3) zumindest die Trägerschicht (7) intakt bleibt, so dass diese eine zusammenhängende Gruppe (9) bilden.

9. Herstellungsverfahren nach einem oder mehreren der vorherigen Ansprüche, wobei die zumindest eine Elektrodenschicht (4, 5), die zumindest eine Piezoschicht (6) und/oder die Trägerschicht (7) selektiv auf dem Träger (2) angeordnet wird, so dass zumindest teilweise voneinander separierte Wandlereinheiten (3) ausgebildet werden.

10. Herstellungsverfahren nach einem oder mehreren der vorherigen Ansprüche, wobei die zumindest eine Elektrodenschicht (4, 5), die Piezoschicht (6) und/oder die Trägerschicht (7) mittels Ätzen und/oder Schneiden entfernt wird.

11. Herstellungsverfahren nach einem oder mehreren der vorherigen Ansprüche, wobei zum Entfernen des Trägers (2) von den Wandlereinheiten (3) eine Verbindung zwischen dem Träger (2) und der Trägerschicht (7) getrennt wird und/oder dass der Träger (2) abgeschliffen und/oder aufgelöst wird.

12. Herstellungsverfahren nach einem oder mehreren der vorherigen Ansprüche, wobei die zumindest eine Wandlereinheit (3) auf einer teilausgehärteten Membran (10) angeordnet wird und/oder
dass die Membran (10) danach vollständig, insbesondere durch Wärmezufuhr, ausgehärtet wird, so dass sich die Wandlereinheit (3) stoffschlüssig mit der Membran (10) verbindet.

13. Herstellungsverfahren nach einem oder mehreren der vorherigen Ansprüche, wobei in der zumindest einen Elektrodenschicht (4, 5), Piezoschicht (6) und/oder Trägerschicht (7) zumindest eine Aussparung (11) ausgebildet wird, so dass eine elektrische Verbindung zu der zumindest einen Elektrodenschicht (4, 5) ausgebildet werden kann.

14. Herstellungsverfahren nach einem oder mehreren der vorherigen Ansprüche, wobei die Wandlereinheit (3) und/oder die Membraneinheit (1) für die elektrische Verbindung zur zumindest einen Elektrodenschicht (4, 5) mit zumindest einem elektrisch leitfähigen Leiter (12, 13) versehen wird, der vorzugsweise mittels eines Druckverfahrens, Abscheideverfahrens und/oder Beschichtungsverfahrens auf diese aufgedruckt wird.

## Claims

1. A manufacturing process for at least one diaphragm unit (1) of a MEMS transducer,
in which multiple piezoelectric transducer units (3), each comprising at least one electrode layer (4, 5) and at least one piezoelectric layer (6), are formed on a carrier (2),
**characterized in that**
the carrier (2) is removed from the transducer units (3),
that at least one of the transducer units (3) is arranged on a diaphragm (10) and is connected thereto in order to form the at least one diaphragm unit (1) and
that multiple diaphragm units (1) are formed with the aid of the diaphragm (10), and/or
that the diaphragm (10) is separated in the area between two diaphragm units (1).

2. The manufacturing process as claimed in the preceding claim, wherein the transducer units (3) are formed on the carrier (2) in such a way that they are separated from one another, and/or
that the transducer units (3) are separated from one another before or after the carrier (2) is removed.

3. The manufacturing process as claimed in one or more of the preceding claims, wherein the transducer units (3) are designed separated from one another and/or are separated from one another in such a way that at least one isolated transducer unit (3) and/or at least one contiguous group (9) of at least two transducer units (3) is formed.

4. The manufacturing process as claimed in one or more of the preceding claims, wherein a carrier layer (7) is formed on the carrier (2), on which the at least one electrode layer (4, 5) and the at least one piezoelectric layer (6) of the transducer units (3) are formed, and/or
that the at least one electrode layer (4, 5), the at least one piezoelectric layer (6), and/or the carrier layer (7) are formed one above the other on the carrier (2).

5. The manufacturing process as claimed in one or more of the preceding claims, wherein a first electrode layer (4) and a second electrode layer (5) are formed on the carrier (2), and/or
that the piezoelectric layer (6) is formed between the first electrode layer (4) and the second electrode layer (5).

6. The manufacturing process as claimed in one or more of the preceding claims, wherein the first electrode layer (4) is formed first of all, then the piezoelectric layer (6), and then the second electrode layer (5), and/or the carrier layer (7) is formed in advance.

7. The manufacturing process as claimed in one or more of the preceding claims, wherein the carrier layer (7), the at least one electrode layer (4, 5), and/or the piezoelectric layer (6) are/is formed over the entire surface of the carrier (2), and/or
that the carrier layer (7), the at least one electrode layer (4, 5), and/or the piezoelectric layer (6) are/is at least partially removed between the transducer units (3), so that the transducer units (3) are at least partially separated from one another.

8. The manufacturing process as claimed in one or more of the preceding claims, wherein only the piezoelectric layer (6) and at least one electrode layer (4, 5) are removed, at least between some transducer units (3), during the separation of the transducer units (3), so that at least the carrier layer (7) remains intact between these transducer units (3), so that these form a contiguous group (9).

9. The manufacturing process as claimed in one or more of the preceding claims, wherein the at least one electrode layer (4, 5), the at least one piezoelectric layer (6), and/or the carrier layer (7) are/is selectively arranged on the carrier (2), so that transducer units (3) are formed, which are at least partially separated from one another.

10. The manufacturing process as claimed in one or more of the preceding claims, wherein the at least one electrode layer (4, 5), the piezoelectric layer (6), and/or the carrier layer (7) are/is removed with the aid of etching and/or cutting.

11. The manufacturing process as claimed in one or more of the preceding claims, wherein a connection between the carrier (2) and the carrier layer (7) is disconnected in order to remove the carrier (2) from the transducer units (3), and/or
in that the carrier (2) is ground off and/or dissolved.

12. The manufacturing process as claimed in one or more of the preceding claims, wherein the at least one transducer unit (3) is arranged on a partially cured diaphragm (10), and/or
that the diaphragm (10) is subsequently completely cured, in particular by supplying heat, so that the transducer unit (3) connects to the diaphragm (10) in an integrally joined manner.

13. The manufacturing process as claimed in one or more of the preceding claims, wherein at least one recess (11) is formed in the at least one electrode layer (4, 5), piezoelectric layer (6), and/or carrier layer (7), so that an electrical connection to the at least one electrode layer (4, 5) can be formed.

14. The manufacturing process as claimed in one or more of the preceding claims, wherein the transducer unit (3) and/or the diaphragm unit (1) are/is provided with at least one electrically conductive conductor (12, 13), which is imprinted thereon preferably with the aid of a printing process, a deposition process, and/or a coating process, for the electrical connection to the at least one electrode layer (4, 5).

## Revendications

1. Procédé de fabrication d'au moins une unité de membrane (1) d'un transducteur MEMS,
dans lequel plusieurs unités de transducteurs piézoélectriques (3) avec chacune au moins une couche d'électrode (4, 5) et au moins une couche piézoélectrique (6) sont formées sur un support (2),
**caractérisé en ce que**
le support (2) est retiré des unités de transducteurs (3),
**en ce que**, pour former l'au moins une unité de membrane (1), l'une au moins des unités de transducteurs (3) est disposée sur une membrane (10) et est reliée à celle-ci, et
**en ce que** plusieurs unités de membranes (1) sont formées avec la membrane (10) et/ou
**en ce que** la membrane (10) est séparée dans la zone entre deux unités de membranes (1).

2. Procédé de fabrication selon la revendication précédente, dans lequel les unités de transducteurs (3) sont formées séparément les unes des autres sur le support (2) et/ou
les unités de transducteurs (3) sont séparées les unes des autres avant ou après le retrait du support (2).

3. Procédé de fabrication selon l'une quelconque ou plusieurs des revendications précédentes, dans lequel les unités de transducteurs (3) sont formées séparément les unes des autres et/ou sont séparées les unes des autres de sorte que soit formé au moins une unité de transducteur (3) individuelle et/ou au moins un groupe (9) cohérent d'au moins deux unités de transducteurs (3).

4. Procédé de fabrication selon l'une quelconque ou plusieurs des revendications précédentes, dans lequel une couche porteuse (7) est formée sur le support (2), sur laquelle sont formées la, au moins une, couche d'électrode (4, 5) et la, au moins une, couche piézoélectrique (6) des unités de transducteurs (3), et/ou
la, au moins une, couche d'électrode (4, 5), la, au moins une, couche piézoélectrique (6) et/ou la couche porteuse (7) sont formées les unes au-dessus des autres sur le support (2).

5. Procédé de fabrication selon l'une quelconque ou plusieurs des revendications précédentes, dans lequel une première et une deuxième couches d'électrodes (4, 5) sont formées sur le support (2) et/ou
la couche piézoélectrique (6) est formée entre la première et la deuxième couches d'électrodes (4, 5).

6. Procédé de fabrication selon l'une quelconque ou plusieurs des revendications précédentes, dans lequel sont formées d'abord la première couche d'électrode (4), puis la couche piézoélectrique (6) et ensuite la deuxième couche d'électrode (5) et/ou, avant, la couche porteuse (7).

7. Procédé de fabrication selon l'une quelconque ou plusieurs des revendications précédentes, dans lequel la couche porteuse (7), la, au moins une, couche d'électrode (4, 5) et/ou la couche piézoélectrique (6) sont formées sur toute la surface sur le support (2) et/ou
la couche porteuse (7), la, au moins une, couche d'électrode (4, 5) et/ou la couche piézoélectrique (6) sont au moins partiellement retirées entre les unités de transducteurs (3), de sorte que les unités de transducteurs (3) sont au moins partiellement séparées les unes des autres.

8. Procédé de fabrication selon l'une quelconque ou plusieurs des revendications précédentes, dans lequel, lors de la séparation des unités de transducteurs (3), seules la couche piézoélectrique (6) et au moins une couche d'électrode (4, 5) sont retirées au moins entre quelques unités de transducteurs (3), de sorte qu'au moins la couche porteuse (7) reste intacte entre ces unités de transducteurs (3), de sorte que celle-ci forme un groupe cohérent (9).

9. Procédé de fabrication selon l'une quelconque ou plusieurs des revendications précédentes, dans lequel la, au moins une, couche d'électrode (4, 5), la, au moins une, couche piézoélectrique (6) et/ou la couche porteuse (7) sont disposées de manière sélective sur le support (2), de sorte qu'il se forme des unités de transducteurs (3) séparées au moins partiellement les unes des autres.

10. Procédé de fabrication selon l'une quelconque ou plusieurs des revendications précédentes, dans lequel la, au moins une, couche d'électrode (4, 5), la couche piézoélectrique (6) et/ou la couche porteuse (7) sont retirées par gravure et/ou découpe.

11. Procédé de fabrication selon l'une quelconque ou plusieurs des revendications précédentes, dans lequel, pour retirer le support (2) des unités de transducteurs (3), une liaison entre le support (2) et la couche porteuse (7) est coupée et/ou
le support (2) est retiré par meulage et/ou dissolution.

12. Procédé de fabrication selon l'une quelconque ou plusieurs des revendications précédentes, dans lequel la, au moins une, unité de transducteur (3) est disposée sur une membrane (10) partiellement durcie et/ou la membrane (10) est ensuite complètement durcie, en partie par apport de chaleur, de sorte que l'unité de transducteur (3) se lie à la membrane (10) par liaison de matières.

13. Procédé de fabrication selon l'une quelconque ou plusieurs des revendications précédentes, dans lequel au moins un évidement (11) est formé dans la, au moins une, couche d'électrode (4, 5), couche piézoélectrique (6) et/ou couche porteuse (7), de sorte qu'une liaison électrique peut être formée avec la, au moins une, couche d'électrode (4, 5).

14. Procédé de fabrication selon l'une quelconque ou plusieurs des revendications précédentes, dans lequel l'unité de transducteur (3) et/ou l'unité de membrane (1), pour la liaison électrique avec la, au moins une, couche d'électrode (4, 5), est/sont pourvue(s) d'au moins un conducteur (12, 13) électriquement conducteur, qui est imprimé sur celle(s)-ci de préférence au moyen d'un procédé d'impression, d'un procédé de déposition et/ou d'un procédé de revêtement.
